# EUROPEAN PATENT SPECIFICATION

(11) **EP 2 593 590 B1**
(45) Date of publication and mention of the grant of the patent: **04.10.2017**
(21) Application number: 11711567.5
(22) Date of filing: 31.03.2011
(51) Int. Cl.: C25D 19/00, C25D 5/02, H01L 21/67, C25D 7/12

(54) **SYSTEM FOR AUTOMATED HANDLING OF MASTERS AND SUBSTRATE**
SYSTEM FÜR AUTOMATISIERTE HANDHABUNG VON VORLAGEN UND SUBSTRATEN
SYSTÈME PERMETTANT UN TRAITEMENT AUTOMATIQUE DE PLAQUES-MÈRES ET D'UN SUBSTRAT

(30) Priority: 16.07.2010 US 364989 P; 15.07.2010 SE 1050795
(43) Date of publication of application: 22.05.2013
(73) Proprietor: Luxembourg Institute of Science and Technology (LIST), 4362 Esch-sur-Alzette (LU)
(72) Inventor: MÖLLER, Patrik, S-112 52 Stockholm (SE); FREDENBERG, Mikael, S-112 34 Stockholm (SE)
(74) Representative: Lecomte & Partners
(86) International application number: PCT/EP2011/055054
(87) International publication number: WO 2012/007191

(56) References cited:
- WO-A1-02/103085
- US-A- 6 136 163
- US-A1- 2006 035 569
- RITZDORF T ED - SHACHAM-DIAMAND YOSI: "Electrochemical Deposition Processes and Tools", 1 January 2009 (2009-01-01), ADVANCED NANOSCALE ULSI INTERCONNECTS : FUNDAMENTALS AND APPLICATIONS, NEW YORK, NY : SPRINGER, US, PAGE(S) 397 - 411, XP008137061, ISBN: 978-0-387-95867-5 [retrieved on 2009-09-19] paragraphs [27.2.1] - [27.2.3]

## Description

### TECHNICAL FIELD

This invention pertains in general to the field of semiconductor manufacturing tools and process automation. More particularly, the invention relates to automation of handling of masters and substrates and more particularly to automated handling of masters and substrates in an integrated Electro Chemical Pattern Replication (ECPR) system.

### BACKGROUND

It is known to automate processing steps in the semiconductor industry. Due to high requirements on the environment and the accuracy of processing steps, semiconductor automation has progressed rapidly.

Tool platforms were developed in response to the demand for higher yields and throughput, which have been further driven by ever-shrinking geometries in integrated circuit production. As features become smaller and smaller, entering the field of nanotechnology, contamination levels that were acceptable previously have now become intolerable.

A tool platform can be considered to be the mainstay of semiconductor automation, since it enables handling of silicon wafers or quartz photo-masks between ultra-clean storage carriers and a variety of processing, measurement and testing systems. It typically contains the key components needed to unload the silicon wafer, deliver it to process units for processing and return the silicon wafer to its carrier upon completion.

In many semiconductor-related industries the competition to achieve measurements of higher resolution and accuracy requires similar attention to the problem of achieving reduced contamination. One of the most important methods to accomplish this is to automate the process and thereby remove contamination associated with product handling by an operator.

An Electro Chemical Pattern Replication (ECPR) method has been described in the international patent application WO 02/103085 A1. For said ECPR method there are pronounced requirements for reduced contamination and high accuracy. Corresponding process steps of said method cannot be carried out manually with high quality, repeatability and process yield.

A problem of prior art techniques to perform ECPR methods is that the quality of printed metal patterns as well as the reliability of the metal transfer process, which affects line yield, is a function of the waiting time and the environment where a master is left waiting between a filling step and a printing step. A master in ECPR is known as an electrode comprising a patterned insulating layer forming cavities and having a conducting electrode layer in said cavities.

Spontaneous and continuous grain modification takes place for many types of pre-filled metals, for instance spontaneous grain growth of electroplated copper at room temperature during the relatively long waiting times between ECPR processing steps of prior art. Due to a less controlled environment in different wafer carriers, the variations in grain size and structure of pre-filled metal in masters are aggravated. Both the quality of printed metal structures, for instance uniformity, defectivity and roughness variations, as well as the reliability of the metal transfer process, giving rise to variations from target metal thickness, is depending on the grain size and surface roughness of the pre-filled material which affects the dissolution during the metal transfer process in electrochemical microcells as used in ECPR printing.

A further problem of prior art techniques to perform ECPR methods is that the quality of printed metal patterns in terms of grains size and roughness as well as adhesion and defect density can be a function of the waiting time and the environment where a master or substrate is left waiting between a surface cleaning and/or activation step and a printing step.

Spontaneous and continuous surface modification processes take place on cleaned and activated surfaces of substrate seed layers as well as, on pre-filled metal surfaces on masters even in relatively well controlled gaseous environments, such as adsorption of electrochemically inhibiting species or formation of oxide. The waiting times between each process step associated with prior art ECPR process, within ambient environment having a gas composition, a temperature, and a particle density, give rise to variations in grain size, roughness, adhesion to seed layer, local thickness uniformity and defect density of printed metal patterns.

Yet a further problem of prior art techniques to perform ECPR methods is that the roughness of printed metal structures after seed etching as well as the etch selectivity between printed metal structures and the seed layer to be etched can be a function of the waiting time and the environment where a printed substrate is left waiting between an ECPR print step and a seed etch step. Again, since spontaneous and continuous grain modification takes place for many types of printed metals, for instance spontaneous grain growth of ECPR-printed copper structures at room temperature, the relatively long waiting times between each process step associated with prior art ECPR process , aggravated by less controlled environments in different wafer carriers, can give rise to increased grain size and variations in grain structure of printed metal patterns as they are subjected to seed etching after printing. Both the resulting roughness of printed metal structures after seed etching as well as the etch selectivity between printed metal material and the seed layer to be etched is depending on the grain size and grain structure of the printed material at the time seed etching is performed.

Yet still a further problem with prior art ECPR processes is that the masters would have to be repeatedly loaded/unloaded from and to a carrier between processing steps. This handling and sliding of masters in and out of carriers causes mechanical wear on the masters, and reduces the lifetime of the masters.

Yet still a further problem is to keep a print unit fully occupied in printing at any time and thereby maximizing the throughput. This is because a second master needs to be filled in parallel with yet another master, a third master that is being cleaned in order to have a filled and cleaned master ready for next process cycle of fill, cleaning and print, at the time as unloading a first master in a first process cycle.

For stand-alone tools for filling, cleaning and printing, the problem is that transport of wafers from one tool to the other is done using standard wafer carriers, typically holding 25 wafers in each carrier. In order to have one carrier simultaneously on all three tools, at least three carriers with masters will be needed in order to keep the process line fully loaded. Even if the number of masters per carrier is reduced to a low number, for instance 5 which can still be practically possible from a carrier swap-cycle perspective, in an attempt to reduce the number of required masters, 15 masters would still be required to maintain a process line loaded. This number of required masters may be too high considered the cost and the availability of specific masters.

Moreover, the nucleation and grain growth mechanisms of electro-deposition in microcells as used for ECPR printing, is to a large extent effected by small amounts of surface contamination and oxidation. An example is oxidation and adsorption of unwanted gaseous substances on the surface of cleaned and activated copper seed layers taking place between a clean & activation step and an ECPR process step.

Thus, there is a need for a system executing process steps of an ECPR method performing electrochemical printing of nano or micro structures with a master on a conductive surface of a substrate with a high timing repeatability in a reduced contamination environment.

### SUMMARY OF THE INVENTION

Accordingly, the present invention preferably seeks to mitigate, alleviate or eliminate one or more of the above-identified deficiencies in the art and disadvantages singly or in any combination and solves at least the above mentioned problems by providing a system, according to the appended patent claims.

The general solution according to the invention is to provide a system for performing electrochemical printing of nano or micro structures, with a high accuracy in a reduced contamination environment.

More particularly, the invention provides an integrated Electro Chemical Pattern Replication (ECPR) system for performing electrochemical printing of nano or micro structures with a master on a conductive surface of a substrate with a high timing repeatability in a reduced contamination environment.

According to aspects of the invention an integrated Electro Chemical Pattern Replication (ECPR) system for performing electrochemical printing of nano or micro structures using a master onto a conductive surface of a substrate is disclosed. Said system comprises a filling unit and a cleaning unit. The method comprises printing the substrate electrochemically, using the master in an ECPR printing process, wherein said ECPR printing process comprises transferring material, deposited in master cavities in a filling unit, as nano or micro structures from the master to the conductive surface of the substrate in electrolyte filled cells, which are formed by the master cavities and the conducting surface of the substrate when placing the master in close contact with the substrate. The method further comprises filling the master with metal in said filling unit and transporting the master from said filling unit to said printing unit prior to printing, or cleaning the master in said cleaning unit prior and/or subsequent to the step of printing, and transporting said master to and from said ECPR printing unit and filling unit or cleaning unit using a robot unit.

Said integrated ECPR system comprises the filling unit and the cleaning unit.

The filling unit of said integrated ECPR system may further comprise an one or more electroplating units, an electro-less deposition unit, an ECPR process unit configured to perform a reverse ECPR process, or a selective Chemical Vapor Deposition, CVD, unit.

The cleaning unit of the integrated ECPR system may further comprise a wet spray process unit, a spin and wet chemical dispense unit, a wet immersion process unit or a dry plasma process unit, wherein the spin and wet chemical dispense unit is configured to perform a wet chemical spin-spray process or a wet chemical spray process.

The integrated ECPR system may further comprise at least one annealing unit being integrated with at least one of the ECPR printing unit, the filling unit and the cleaning unit.

The robot control unit of the integrated ECPR system is configured to control the robot unit to grip, hold, transport and release the master or the substrate one at a time in the single wafer flow.

The housing of the integrated ECPR system may further be configured with one or more load ports for accepting and returning carriers of masters and substrates.

The integrated ECPR system may further comprise an aligning unit configured to align the substrate and the master into first positions thereof.

The integrated ECPR system may further comprise a master buffering unit configured to temporarily house one or two masters, for provision of a used master to an end effector for transporting said used master to the filling unit.

The integrated ECPR system may further comprise a counter configured to increment a counter value upon passage of a master, for counting the number of prints performed by using each master, and where the scheduler further is configured to determine whether the master is to be returned to a master carrier enabling recycling of the master, or to be further used within the integrated ECPR system.

The aligning unit of the integrated ECPR system may further comprise a flipping unit configured to change the orientation of the master and the substrate, such that the master and the substrate will have a first orientation in the master carrier and the substrate carrier, respectively, while one of the master and the substrate will have a second orientation in the ECPR printing unit.

An end effector of the integrated ECPR system may, by means of a robot unit, be controlled to transport the master from the at least one cleaning unit to the aligning unit, and from the aligning unit to the ECPR printing unit, and to transport the substrate from the aligning unit to the ECPR printing unit.

The robot unit of the integrated ECPR system may further comprise a second end effector configured to grip, hold and release the master and the substrate, and the second end effector by means of a controlled robot unit, is controlled to transport the master from the ECPR printing unit to the at least one cleaning unit, and to transport the substrate from the printing unit to the at least one cleaning unit.

The tool platform of the integrated ECPR system may further comprise at least one of a temperature control unit and a particle filtering unit, wherein the temperature control unit is configured to control the temperature of the interior of the integrated ECPR system, and the particle filtering unit is configured to filter inlet air for the integrated ECPR system.

The temperature control unit of the integrated ECPR system may further be configured to control the temperature of process fluids for at least one of the filling unit, the cleaning unit and the ECPR printing unit.

The integrated ECPR system may further comprise a second cleaning unit wherein one cleaning unit comprises an etching unit configured to etch away remaining metal from the master after transfer of metal from the master to the substrate in the ECPR printing unit, and configured for etching or activation of the seed layer of the substrate, and wherein the second cleaning unit comprises a particle removing unit for rinsing and drying the master and the substrate.

The integrated ECPR system may further comprise an annealing unit configured to anneal the substrate having metal transferred from the master.

The integrated ECPR system may further comprise a substrate and master flow simulator and a flow optimizer.

The integrated ECPR system may further comprise a system level control software comprising a wafer scheduler application for scheduling in time the transport of substrates and/or masters between, as well as the processing itself within various processing units, comprising at least one of the filling unit and the cleaning unit, and the ECPR printing unit.

The wafer scheduler application within the system level control software of the integrated ECPR system may further be configured to control hand-shakes between the units, and selection of printing recipes for printing of the substrates and data logging of steps and processes being performed within the integrated ECPR system.

The wafer scheduler application within the system level control software of the integrated ECPR system may further be configured to control error signals and alarms for the units. A method within an integrated Electro Chemical Pattern Replication, ECPR system for performing electrochemical printing of nano or micro structures using a master onto a conductive surface of a substrate, the system comprising an ECPR printing unit and at least one of the group of a filling unit and a cleaning unit, is further disclosed.

The method comprises performing printing the substrate electrochemically, using the master in an ECPR printing process, wherein said ECPR printing process comprises transferring material, deposited in master cavities in a filling unit, as nano or micro structures from the master to the conductive surface of the substrate in electrolyte filled cells, which are formed by the master cavities and the conducting surface of the substrate when placing the master in close contact with the substrate. Transferring material may alternatively be performed by dissolving material from the substrate while depositing said material in the master by use of the electrolyte filled cells, which are formed by the master cavities and the conducting surface of the substrate when placing the master in close contact with the substrate. The method further comprises filling the master with metal in said filling unit and transporting the master from said filling unit to said printing unit prior to printing, or cleaning the master in said cleaning unit prior and/or subsequent to the step of printing. In addition, the method comprises transporting said master to and from said ECPR printing and filling unit or cleaning unit using a robot unit.

The robot unit within the method, which robot unit has at least one end effector, is configured to transport said master to and from said ECPR printing unit and filling unit or cleaning unit.

The method may further comprise annealing of the printed substrate after the step of ECPR printing.

The method may further comprise performing at least one of cleaning and activating of a substrate, prior to the ECPR printing, by using a wet chemical spray process, a spin and wet chemical dispense process, a wet immersion process or a dry plasma process.

The method may further comprise performing seed etching of a wafer after ECPR printing, using at least one of a wet chemical spin etch process and a wet chemical spray etch process, a wet immersion etch process or a dry plasma etch process.

The method may further comprise performing cleaning and drying of a substrate seed wafer after ECPR printing.

The method may further comprise transporting a substrate from a substrate carrier, performing printing of the substrate, followed by transporting the substrate to the substrate carrier.

The method may further comprise cleaning the substrate after the step of printing the substrate and before transporting it to the substrate carrier.

The method may further comprise performing seed etching of the substrate after printing, but before the step of cleaning the substrate.

The method may further comprise performing annealing of the substrate after printing but before the step of seed etching the substrate.

The method may further comprise cleaning the substrate prior to performing the printing step.

The method may further comprise cleaning and activating of a master, prior to ECPR printing or prior to the step of filling the master with metal, wherein in the step of cleaning and activation is performed using a wet chemical spray process, a wet immersion process, or a dry plasma process.

The step of filling within the method for performing electrochemical printing of nano or micro structures, may further comprise filling a master with anode material prior to performing ECPR printing, by performing electroplating, electro-less deposition, deposition by reverse ECPR, or selective Chemical Vapor Deposition, CVD in cavities of a master.

The method may further comprise at least one of etching and cleaning of the master, after the filling step and before or after the printing step, using a wet chemical spray process, a wet immersion process, or a dry plasma process.

The method may further comprise transporting a master from a master carrier, performing printing by using the master, followed by transporting the master to the master carrier, further comprising performing at least one of cleaning and etching of the master, before, after or before and after, the step of printing.

The method may further comprise transporting a master from a master carrier, performing filling in a filling unit, performing printing by using the master, and transporting the master to the master carrier, or transporting the master to the filling unit for performing pre-filling of the master, whereby a master count is incremented for the master when the master is transported to the filling unit.

The method may comprise at least one of filling the master and, at least one of cleaning and etching of the master, prior to the step of printing by using the master.

The method may further comprise at least one of: at least one of cleaning and etching, and filling the master, prior to the step of printing by using the master.

Performing at least one of cleaning and etching within the method for performing electrochemical printing of nano or micro structures, may be performed after the step of printing by using the master.

The method may comprise transporting a master from a master carrier, performing cleaning the master, filling the master, performing cleaning and optionally etching of the master, printing by using the master, performing etching of the master, performing cleaning, followed by transporting the master to the master carrier, or transporting the used master to the filling unit for performing filling of the master, whereby a master count is incremented for the master when the master is transported to the filling unit.

The method involving the step of filling of metal to the master may further comprise performing annealing after the step of pre-filling of metal to the master. A computer readable medium comprising computer readable program code is further disclosed.

When inserting said computer readable program code in a computer at least associated with an integrated ECPR system, it may execute a method such that electrochemical printing of nano or micro structures can be performed with a master on a conductive surface of a substrate with a high spatial accuracy in a reduced contamination environment.

Master refers herein to an electrode comprising a patterned insulating layer forming cavities and having a conducting electrode layer in said cavities. The integrated ECPR system of the present invention has a vast number of advantages over the prior art, of which a few are:
Provision of an environment control in the form of a contamination control brings the advantage of a higher quality and repeatability of printed ECPR metal patterns and higher process yields than was previously possible.

Temperature control of en enclosed ECPR system enables pattern replication with a higher accuracy and higher reproducibility than was feasible previously.

Provision of a scheduler application enables timing control of timing dependent processes, bringing higher quality, such lower variations in roughness, lower defectivity, improved thickness uniformity and higher reproducibility, than previously feasible.

Timing and environmental control between the steps of pre-filling a master and printing the substrate using the master, affects printing quality.

Both the quality of printed metal structures, for instance uniformity and roughness variations, as well as the reliability of the metal transfer process, for instance variations from target metal thickness, is depending on the grain size and surface roughness of the pre-filled material which affects the dissolution during the metal transfer process in electrochemical microcells as used in ECPR printing.

Minimized and highly repeatable waiting times for master and substrate between processing units in a controlled environment are critical for the quality of the printed metal patterns as formed in the printing unit.

Timing and environment control between the steps of cleaning/surface activation and printing the substrate using the master, affects surface conditions of the master and the seed layer of the substrates.

By integrating the filling unit and the printing unit into one integrated ECPR system, the elapsed time for wafer transport between wafer treatment in said pre-filling time and the subsequent printing unit as well as time variations can be minimized. By providing a well controlled local environment inside the integrated ECPR system both the total amount of spontaneous grain modification as well as the wafer-to-wafer variation between metal filling and printing can be minimized. The effect is improved control of the dissolution of pre-filled metal from the master during printing, enabling improved uniformity and roughness of printed metal as well as better reliability of printing by minimizing the risk for forming electrical short-cuts in microcells.

By integrating the process units for cleaning and printing into one ECPR system according to some embodiments of the present invention, the waiting time and wait time variations wafer-to-wafer, is minimized. The total amount of surface modification as well as the wafer-to-wafer surface variations between cleaning and printing can be minimized by providing a well controlled mini-environment inside the integrated system. The effect is improved grains size and roughness control, improved adhesion between printed structures and seed layers as well as reduced defectivity such as dislocations and voids, resulting from cleaner and more repeatable metal surfaces for seed layers and prefilled metal in printing within the integrated ECPR printing unit.

Timing and environment control between the steps of printing and seed etch step of the substrates affect the grain size of metal and thereby roughness post seed etch as well as the selectivity between plated metal and seed layer metal.

By integrating the printing process unit and cleaning unit configured for seed etching into one integrated ECPR system, the waiting time and waiting time variations wafer-to-wafer, is minimized. By providing a well controlled local environment inside the integrated ECPR system both the total amount of spontaneous grain modification as well as the wafer-to-wafer variation between printing and seed etching can be minimized. Advantageous effects are improved control of the surface roughness and etch selectivity to the seed layer during the seed layer etching in the cleaning unit configured for etching.

Provision of a scheduler application further enables optimization such that the number of master can be minimized for a high throughput of substrates, or that the throughput of substrates is maximized for a small number of masters.

By using a single-wafer flow of master and substrates, the elapsed time until the first substrate has been completed and can leave the integrated ECPR system, the so called first-wafer delay, is substantially decreased as compared to batch-wise handling of, at least, substrates. At the time the first printed substrate from an integrated ECPR system is thus completed, a number of substrates are still being processed, using batch-wise processing, without having a single substrate being completed. This is a clear drawback especially in relatively small series of substrates.

### BRIEF DESCRIPTION OF THE DRAWINGS

These and other aspects, features and advantages of which the invention is capable of, will be apparent and elucidated from the following description of embodiments of the present invention, reference being made to the accompanying drawings, in which
Fig. 1 is a schematic illustration of a batch-wafer flow of master and substrate according to prior art ECPR techniques;
Fig. 2 is a schematic illustration of a single wafer flow of a master and a substrate, according to some embodiments of the present invention;
Fig. 3 is a schematic illustration of a simplified flow path of a master and a substrate in an integrated ECPR system, according to some embodiments of the present invention;
Fig. 4 is a block system presentation of an integrated ECPR system, according to some embodiments of the present invention;
Fig. 5 is a schematic illustration of an integrated ECPR system according to some embodiments of the present invention;
Figs. 6 and 7 are schematic flow paths of a master and a substrate, respectively, between processing units of an integrated ECPR system, according to some embodiments of the present invention;
Figs. 8A and 8B are schematic illustrations of cross-sections relating to ECPR etching, according to some embodiments of the present invention; and
Figs. 9A and 9B are schematic illustrations of cross-sections relating to ECPR plating, according to some embodiments of the present invention.

### DESCRIPTION OF EMBODIMENTS

There is thus a need for an integrated ECPR system capable of performing electrochemical printing of nano or micro structures with a master on a conductive surface of a substrate within a local environment and with a high accuracy.

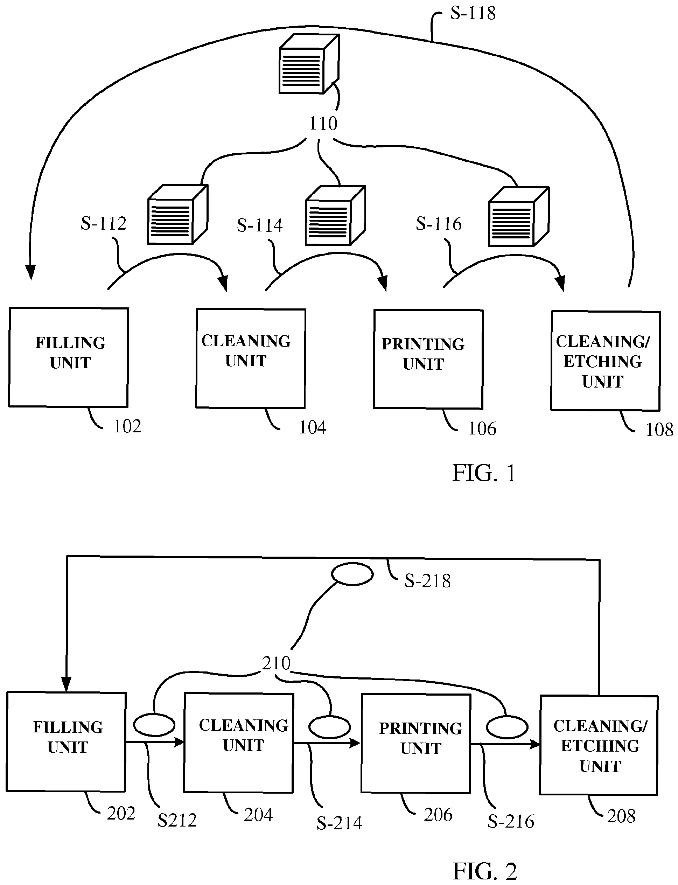

Figure 1 illustrates a schematic batch flow process line according to prior art EPR techniques where master and/or substrate are transported in batches between stand alone processing units, such as between a filling unit 102, a cleaning unit 104, a printing unit 106 and a cleaning/etching unit 108. Depicted in figure 1 are also carriers 110, where each comprises either a batch of master or a batch of substrates.

Known carriers comprise an open wafer cassette, a Front Opening Universal Pod (FOUP) or a Standard Mechanical Inter Face (SMIF).

By the time all master have been processed by one processing unit, the carrier comprising the entire batch is transported to the following processing unit. For example, when all masters have been filled with metal in the filling unit 102, the carrier 110 is transported to the cleaning unit 104, in step S-112.

After all masters have been cleaned by the cleaning unit 104, the carrier can be transported to the printing unit 106 in step S-114. By the time all masters have been used in printing, the master-comprising carrier is transported, in step S-116, to the cleaning/etching unit 108, which can be realized as a cleaning unit that is configured to clean and/or etch.

By the time all masters are cleaned and//or etched in the cleaning/etching unit 108, the carrier can be transported in step S-118 to the filling unit.

By transporting master in carriers having batches of masters, the time elapsed between two processing steps for the same master is thus not only the time required for transporting the carrier having the batch between the two processing units but also a considerable waiting time that is proportional to the number of masters comprised in one batch and the unit process time of the respective process unit.

It is exemplified that carriers in this way can comprise a batch of masters or substrates for which reason a flow using carriers for transport of master or substrates between processing units can be denoted a batch-flow. Since it takes time to complete each processing step and to fill the carrier with masters or substrates, the carrier cannot transport the masters or substrates to a subsequent processing unit before the carrier is filled or at least comprises the pre-determined number of masters or substrates in usage. The waiting time can thus be relatively long between processing steps.

It is moreover well known that metal materials such as copper can undergo a structural change between processing units in processing flows. These waiting times can give rise to variations of the grain size and the structure of pre-filled material in the master, as well as surface modification, adsorption of chemical species or particle deposition on previously cleaned and activated metal surfaces.

This is a disadvantage for the reason that the quality of the printed structures in terms of roughness variations, defectivity and metal thickness uniformity as well as the repeatability of the metal transfer process are depending on the grain size of the pre-filled material and its surface conditions, and the grain size of the pre-filled material changes in time.

These disadvantages are aggravated by a less controlled environment in different carriers, which may give rise to further variations in grain size and pre-filled material structures.

Needless to say the throughput of high quality master and substrates through an ECPR production line is affected by the waiting time between processing steps in neighboring processing units.

Within embodiments of the present invention master and substrates are transported one at a time by an end effector of a robot unit between different processing units in a well controlled environment, enabled by the use of a tool platform, minimizing the waiting time itself and variations thereof between process steps. By using a housing of an integrated ECPR system, a well controlled environment for processing units within said ECPR system is further facilitated.

The robot unit is typically a master and substrate transport unit, and may comprise a conveyer belt, an air levitated transfer rail, a multi-axes robot, a scara robot or another applicable master and substrate transport means.

Figure 2 schematically illustrates a single-wafer flow of at least a master within an integrated ECPR system. From a filling unit 202, wherein the master is filled with metal, the single master 210 is transported in step S-212 to a cleaning unit 204 wherein the master 210 is cleaned by using a wet chemical spray process, a spin and wet chemical dispense process, a wet immersion process or a dry plasma process. From the cleaning unit 204 the master is transported in step S-214 to a printing unit 206, wherein a pattern is replicated onto a substrate by using a filled master 210. Having printed the pattern by using the master in the printing unit 206, the single master 210 is transported in step S-216 in the single-wafer flow to the cleaning/etching unit 208, which can be configured to etch and/or to clean the master using a wet chemical spray process, a spin and wet chemical dispense process, a wet immersion process or a dry plasma process. Having etched or cleaned the master in the etch/cleaning unit 208 the single wafer is then transported to the filling unit 202 in step S-218, wherein a master counter is incremented for each cycle a specific master is used.

By using a single-wafer flow, the waiting time between the processes in consecutive processing steps per master or substrate can be minimized. Moreover variations in waiting time can be kept to a minimum since all steps can be reproduced in a practically identical environment, as experienced by the masers and substrates.

Down below, the integrated ECPR system as well as a method for printing substrates in an ECPR system will be described.

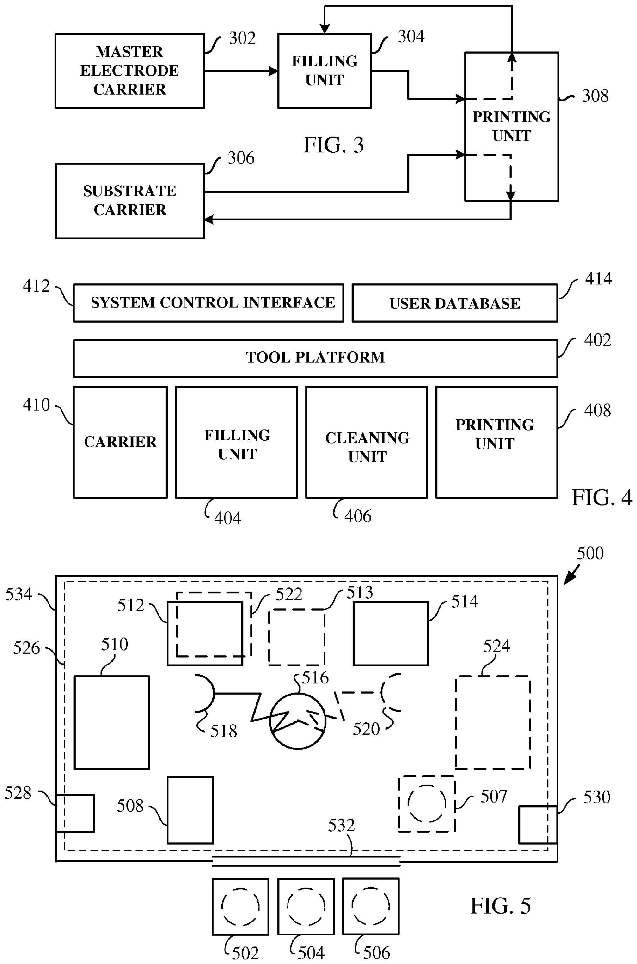

Figure 3 illustrates a simplified single wafer flow path of a master and a substrate in the integrated ECPR system, according to some embodiments of the present invention.

In general a master, having cavities, is filled with a material, prior to printing, therefore pre-filled, such as metal, in said cavities after which the master and a substrate are pushed together within a printing step with electrolyte in-between, forming micro-cells filled with electrolyte defined by the substrate and cavities of the master whereby the master pattern is replicated onto the substrate applying a potential between the pre-filled material and the substrate whereby pre-filled material is transferred inside said electrolyte filled micro-cells and deposited onto the substrate by an electrochemical reaction. Deposited as used herein, can also be called electroplated electrodeposited or plated.

A substrate can for instance be a wafer which may comprise at least a conducting seed layer for receiving printing.

From a master carrier 302, a master can be transported in a single wafer flow to a filling unit 304 for filling of metal onto the master. The metal filled master is then transported to a printing unit 308 in which the master and a substrate, transported from a substrate carrier 306, is pushed together. Metal that is pre-filled on the master is now plated or printed onto the substrate.

It can be mentioned that each carrier may be equipped with a Radio Frequency Identifier, RFID. Each master and substrate may also be equipped with a RFID tag. The integrated ECPR system may comprise an RFID carrier ID reader and/or a wafer laser scribe ID reader, for identifying the ID of each carrier and each master and substrate, respectively.

Figure 4 presents a block system illustration of an integrated Electro Chemical Pattern Replication (ECPR) system, according to some embodiments of the present invention.

The integrated ECPR system according to some embodiments comprises a platform 402, a filling unit 404, a cleaning unit 406 and a printing unit 408, and a wafer carrier 410. It can be noted already at this stage that the cleaning unit 406 may also or alternatively be configured to perform etching. The platform 402 is arranged to serve said units as comprised in the integrated ECPR system with wafers from the wafer carrier 410 by means of a robot unit, which is not shown in this figure.

One type of a cleaning unit can be an ECPR cleaning unit, which is a semiconductor manufacturing tool unit that can perform steps involved in etching metal from masters or substrates as well as cleaning the masters or substrate surfaces from chemical and particle contamination. ECPR cleaning units can be configured to have a single or multiple process chambers for etching and cleaning masters and substrates.

A computer control unit may be provided within the ECPR cleaning unit and can be used to manage various cleaning recipes, execute said recipes, monitor etch process, perform data logging and deliver reports on measured parameters and performance of each process step. The computer control unit can be configured to communicate with the system level control software of the integrated ECPR system using a pre-defined communication protocol for communicating data such as the respective process parameters, cleaning and/or etching recipes, log-files and cleaning and/or etching reports, cleaning status signals, hand-shake signals and cleaning error signals.

The step of cleaning and etching can comprise wet chemical spin etch process, a wet chemical spray etch process, a wet immersion etch process or a dry plasma etch process.

In some embodiments of the present invention, the cleaning unit is designed and configured to perform wet chemical etching and cleaning of masters or substrates in one or more single wafer spin-spray processing chambers. In these embodiments the master or substrate to be process can be received by the unit and held on a rotating chuck while fixed nozzles within the unit or nozzles on movable dispense arms are used to dispense wet chemicals over the ECPR master or substrate surface. The dispensing of chemicals can be performed by a combination of fixed nozzles and sweeping nozzles on dispense arms in a way that together with the rotation of the master or the substrate optimizes the uniformity of the etching, cleaning or cleaning and etching operation over the master or substrate surface. Different dispense nozzles, such as fan-spray, high pressure spray, high velocity or pressure spray, point-of use mixing nozzles and/or mega sonic transducers can be used to achieve improved agitation and dispense uniformity, thereby optimizing etching operations, and/or improved agitation and enhanced physical interactions with the wafer surface, thereby optimizing surface and particle cleaning operations. ECPR cleaning units and etch units can be configured with multiple mixing and supply tanks for preparing and dispensing etching and cleaning chemicals in multiple chemical supply lines connected to the different dispense nozzles. All chemical supply lines can be configured with high purity filtration and temperature control units to guarantee minimum levels of contamination and accurate control of the temperature of the process chemicals, rinse water and gases used in the process sequences. Chemical circulation tanks with optional filtering and pumping functionality may be used in order to enable re-use of chemistry on multiple masters or substrates.

In some other embodiments of the present invention the cleaning unit can be designed and configured to perform wet chemical etching and cleaning of masters or substrates by immersion in a wet processing bath with agitation and filtration. ECPR cleaning units for immersion processing can be configured with multiple mixing and supply tanks for preparing and dispensing etching and cleaning chemicals in multiple chemical supply lines connected to the baths. All chemical supply lines can be configured with high purity filtration and temperature control units to guarantee minimum levels of contamination and accurate control of the temperature of the process chemicals, rinse water and gases used in the process sequences. Chemical circulation tanks with optional filtering and pumping functionality may be used in order to enable re-use of chemistry on multiple masters or substrates.

In yet other embodiments of the present invention the ECPR cleaning unit can be designed and configured to perform dry etching or plasma activation using plasma-based etch and/or activation processes of the integrated ECPR system. Such an ECPR cleaning unit configured for etching may have gas supply lines and a plasma generation power supply connected to a dry etch process chamber where dry etching of metal layers can be performed.

Moreover, the integrated ECPR system can also comprise a system control interface 412 and a tool database 414, for controlling a robot control unit and for controlling the operation of the units as comprised in the integrated ECPR system. In addition, the system control interface may be operated by an operator or remotely by using a factory automation interface. The system control interface can therefore be used for tailoring of processing steps within the ECPR system by each user or use case, by using the tool database 414.

The integrated ECPR system will now be presented in more detail with reference to figure 5, illustrating an integrated ECPR system 500 for handling of wafers such as masters and substrates in a semiconductor ECPR fabrication single-wafer flow process, according to some embodiments of the present invention. The integrated ECPR system 500 comprises a number of process units 508-524 for carrying out various processes in a single-wafer flow such as electrochemical plating or deposition processes, ECPR printing process, etching processes, cleaning processes, and the like.

Single-wafer flow depicts that each master and substrate is processed in each processing unit one at a time and transported between units by an end effector one at a time. This does however not exclude that several masters and/or substrates can be processed in different processing units at the same in parallel. By processing masters and substrates one at a time in processing units brings a number of advantages which will be apparent down below.

The integrated ECPR system can thus perform the process steps of electrochemical printing of nano or micro structures with a master on a conductive surface of a substrate.

The master is a template electrode that can be inserted into an ECPR print unit in order to replicate a metal pattern of the ECPR master onto a substrate by using the ECPR process.

One purpose of the master is to provide electrical connection to all local etching or plating cells that are formed when compressing the master and the substrate into close contact with one another and, at the same time, to provide electrical insulation to the areas where electrochemical action is undesired, i.e. at the contact areas between an insulating pattern layer and the substrate. To enable a well-defined pattern transfer, even for relatively rough substrate surfaces having a defined topography, a conformable behavior is needed. This can be satisfied by a flexible or compressible layer within the master construction.

Masters can be manufactured using conventional micro fabrication methods.

The integrated ECPR system may comprise a substrate carrier 502 and a master carrier 504. The substrate carrier and the master carriers 502, 504 are arrangements for receiving and holding substrates and masters, respectively.

These can be open cassettes and/or carriers, such as Front Opening Universal Pods (FOUP) and carriers with Standard Mechanical Inter Face (SMIF) of masters and substrates. These cassettes and/or carriers of common diameters, such as 100 to 300 mm, typically 200 mm or 300 mm, are configured to retain masters and/or substrates in a position allowing a robotic end effector 518 to extract an electrode or a substrate, from the said cassettes and/or carriers. In addition to the robotic end effector 518, a second robot unit controlled end effector 520 may also be provided. The end effectors are linked to a robot unit 516, which in turn can be connected to a control unit, comprising a computer, a memory unit, support circuits etc., for controlling the movement of the end effectors 518, 520. The master and the substrate can thereby be transported between the process units 508 -524 by the robotic end effectors 518, 520.

The integrated ECPR system furthermore comprises a printing unit 510 configured to perform electrochemical printing of nano or micro structures with a master on a conductive surface of a substrate. At least one or optionally two cleaning units 512, 522 are also comprised in the integrated ECPR system configured to clean the master and the substrate. The master and the substrate can furthermore be pre-aligned by a pre-aligning unit 514. Substrates or masters may optionally be annealed by an annealing unit 513, which is a semiconductor manufacturing tool unit that can anneal a metal film on an electrode or a wafer. Annealing units may be configured to have a single or multiple process chambers for thermal treatment of either masters or substrates in a controlled atmosphere. Anneal units can be configured with gas supply lines for N₂, H₂, Ar or an other inert gas, forming gas mixtures that are used to create a well controlled environment with minimum amounts of oxygen within annealing chamber(s) of the annealing unit. A computer control unit within the annealing unit can be used to manage clean and etch recipes, execute recipes, monitor the process, perform data logging and deliver reports on measured parameters and performance of each process step. The computer control unit can be configured to communicate with the ECPR system level control software of the integrated ECPR system using a pre-defined communication protocol for data such as the respective process parameters, anneal recipes, log-files and reports, status signals, hand-shake signals and errors.

The pre-aligning unit 514, also called pre-aligner is a wafer handling unit that can perform steps involved in measuring and optionally adjusting the spatial position of a master or substrate in a flow for handling masters and substrate, involving at least one robot unit end effector transporting master or substrates between multiple processing units or processing units within an integrated ECPR system.

In some embodiments of the present invention the pre-aligning unit 514 is configured to measure the position and orientation of a wafer and thereafter transport the measured wafer position to a robot control unit that then adjusts the position of the robot unit end effector at pick up or hand over position so that the wafer is transported to a certain processing unit with a certain placement accuracy.

In some embodiments of the present invention the pre-aligning unit is configured to measure the position and orientation of a master or substrate and to mechanically adjust the position and/or orientation of said wafer, such that it can be picked up by a robot end effector with certain placement accuracy, enabling hand over to a processing unit with certain placement accuracy. Pre-aligning units can typically be used to achieve a master or substrate placement accuracy of +/-50 µm or better within an integrated ECPR system, using a wafer handling robot unit.

In yet other embodiments of the invention the pre-aligning unit is configured with two wafer aligning positions, one for known clean masters or substrates that are known to be clean and one for potentially contaminated masters or substrates.

The pre-aligning unit 514 may also comprise a flipping unit arranged to change the orientation of a master or a substrate.

Before starting the printing process the master can be filled with a metal, by using a filling unit 508.

A carrier 507 may serve as a buffer unit for either the master or the substrate for increasing the throughput of substrates of the process.

The master or substrate carriers 502, 504, 506 may moreover be an arrangement for receiving and holding masters or substrates, and may be one of the types: Front Opening Universal Pods (FOUP), Standard Mechanical InterFace (SMIF), or open cassette type.

The filling unit may be an ECPR filling unit that is semiconductor manufacturing tool unit that can perform steps involved in selectively filling trenches of a master with a controlled amount of metal prior to the ECPR print step at which the pre-filled metal is transported from the master to the substrate. "Pre-filled" refers here to being filled prior to the print step. ECPR filling units can be configured to comprise a single or multiple process chambers for filling masters. A computer control unit within the unit can be used to manage filling recipes, execute filling recipes, monitor the ECPR filling process, perform data logging and deliver filling reports on measured parameters and performance of each filling step.

The computer control unit can be configured to communicate with the system level control software of the integrated ECPR system using a pre-defined communication protocol for communication of data such as the respective process parameters, filling recipes, log-files and filling reports, filling status signals, hand-shake signals and filling errors.

In some embodiments of the present invention the filling unit is designed and configured to perform electrochemical deposition of metal, i.e. electroplating, in the trenches of a master. Such a filling unit may comprise automatic control systems for electrolyte volume control, dosing of acid and chemical additives as well as circulation systems for the electrolyte comprising high purity filtration and temperature control capabilities. A filling unit for electroplating according to some embodiments of the invention is configured to perform steps involved in receiving a dry master from a robot unit end effector, clamping and contacting it on a wafer holder. The filling unit may thereafter perform steps for filling the trenches with metal, typically involving steps of pre-wetting the master, optionally while rotating, immersing it in a plating bath, plating the desired amount of metal into the trenches in a single or multiple plating steps by control from a plating power supply. In addition the filling unit may then rinse and/or dry the master before unclamping it in the wafer holder, allowing for unloading of the master using a robot unit end effector. Filling units for electroplating can be configured with fountain plating reactors where the electrolyte is supplied upwards in a circular reactor towards the master that is positioned face down, typically on a rotating wafer holder, or using a vertical or horizontal paddle cell where agitation of electrolyte at the master/electrolyte interface is performed by moving single or multiple agitation paddles close the surface of the master.

In some embodiments of the present invention the filling unit is designed and configured to perform so called electro-less deposition of metal in the trenches of a master, by applying autocatalytic metal deposition from a chemical solution with or without reduction agents present in the solution.

In some embodiments of the present invention the filling unit is designed and configured to perform deposition of metal by reverse Electro Chemical Pattern Replication (ECPR), in the trenches of a master. The filling unit used in these embodiments can have a substrate material as metal source for filling a master in contact with the substrate that is made anodic whereas the master is made cathodic when applying external electric potentials in order to transfer metal from the substrate to the trenches of the master, thus performing ECPR etching of the substrate and ECPR plating of the master.

In some embodiments of the present invention, the filling unit is designed and configured to perform selective Chemical Vapor Deposition, CVD, of metal in the trenches of a master.

Returning to the components of the integrated ECPR system, an additional printing unit 524 may also be provided within said integrated ECPR system. The robot unit 516 comprising the two end effectors 518, 520 can be provided connected to a robot platform 526.

The end effectors 518, 520 are preferably of the backside edge grip or of the backside vacuum paddle type. By using backside edge grip or vacuum paddle end effectors, only one side of the master or substrate will be touched for which reason particle contamination may be further reduced.

In order to provide environmental control of the integrated ECPR system a housing 534 enclosing the units 502-526 may moreover be arranged in the integrated ECPR system. This housing may comprise a temperature control unit 528 for maintaining a constant temperature in its interior. The temperature control unit 528 may also be configured to temper process fluids for at least the filling unit 202, 304, 404, 508, 610 and potentially also for the cleaning unit 512, 522, 612, before printing within the printing unit 510, 414.

In addition, a contamination control unit 530 having an air filter may be also be provided to maintain a reduced content of air particles in the interior of the housing 534.

Moreover, a load port 532 may be provided in the housing 534 for efficiently loading and unloading the master or wafer carriers 502, 504 and 506 arranged to hold and release masters or substrates. The load port 532 thus enables maintaining a controlled local environment of the interior or the housing 534.

In the following a description of an ECPR method will be presented, and references will be made to the respective processing units of the integrated ECPR system.

Moreover, the following description focuses on embodiments of the present invention applicable to the system for performing ECPR. In particularly, the present invention refers to a system for performing a process of ECPR in an automated manner, whereby the processing and processing time of substrates may result in higher efficiency and higher accuracy, since critical parameters are controlled in an, at least close to, optimized way.

The ECPR process is an electro-chemical pattern replication process whereby transfer of metal patterns may be performed by use of a master having trenches, in which pre-filled metal can be dissolved.

By applying one external electric potential to a conductive seed layer of the substrate and another electric potential to the master, the conductive seed layer can be made cathodic and the master can be made anodic.

The dissolved metal can be transferred as ions through an electrolyte in electro-chemical microcells formed by said trenches between the master and a substrate when placing the master and the substrate in close contact with one another. The transferred ions can thus build-up and form the replicated pattern.

The seed layer on the substrate may comprise one or several layers of a conductive material. This material may be a metal or another conductive material.

The seed layer of the substrate can be cleaned and activated before usage in the ECPR process. The cleaning method can include the use of organic solvents and/or inorganic solvents. Cleaning can also be performed by applying oxygen plasma, argon plasma and/or hydrogen plasma or by mechanically removing impurities. Activation of the seed layer surface can be performed with solutions removing oxides.

A master for ECPR printing may comprise a carrier which is conducting or semiconducting in at least some parts, a conductive electrode layer, and an insulating pattern layer defining cavities in which ECPR etching or plating can occur in the ECPR process by using automated ECPR printing for instance by applying an ECPR printing unit.

The conductive electrode layer can be an anode in ECPR plating and a cathode in ECPR etching. The conductive electrode layer is substantially inert in the electrolyte solution used.

ECPR printing as used herein may thus refer to either ECPR plating or ECPR etching.

The master can be used to produce one or multiple layers of structures using an ECPR printing unit. The ECPR printing unit may perform:
a) positioning the master in contact with a substrate, such as a seed layer, to form multiple electrolytic cells, defined by the conductive electrode layer, the insulating pattern layer, and the seed layer; and
b) forming structures in said seed layer by etching or forming structures on said seed layer by plating anode material already pre-deposited in the cavities of the master.

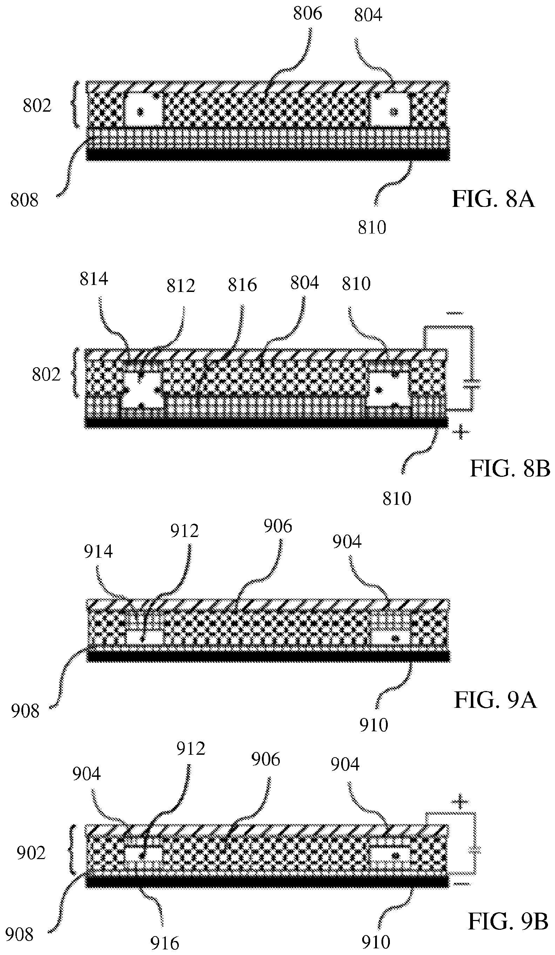

With reference to figures 8A and 8B, ECPR etching will be described in more detail. In the first step (a), for the case of ECPR etching a master 802 comprising an electrically conducting electrode layer 804, of at least a material that is less dissolvable than the pre-filled material, such as platinum, and an insulating pattern layer 806, is positioned in close physical contact with the conducting top layer or seed layer 808, on the substrate 810 in the presence of an electrolyte 812, forming electrochemical cells, filled with electrolyte, defined by the cavities of the insulating structures 806 on the master 802.

Positioning the master 802 in close contact with the top layer on the substrate 810 may include aligning the master insulating pattern 806 to the patterned layer on the substrate 810. This step can include the use of alignment marks of the master which alignment marks can be aligned to the corresponding alignment marks on the substrate.

The electrolyte may comprise a solution of cations and anions appropriate for electrochemical etching and/or plating.

In the second step (b), structures of conducting material can be formed using an ECPR printing unit by etching applying a voltage, using an external power source, to the master 802 and to the seed layer 808 on the substrate 810 for creating an electrochemical process simultaneously inside each of the electrochemical cells defined by the cavities of the master 802 and the top layer on the substrate 810. When the voltage is applied in such a manner that the seed layer 808 on the substrate 810 is anode and the conducting electrode layer 804 in the master 802 is cathode, the seed layer material can be dissolved and at the same time material 814 can be deposited inside the cavities of the master 802. The structure(s) formed from the remaining seed layer 808 is a negative image of the cavities of the insulating pattern layer 806 of the master 802, whereby ECPR etched structures 816 are formed..

With reference to figures 9A and 9B, ECPR plating will be described in some detail. In the first step (a), for the case of ECPR plating, a master 902 comprising an electrically conducting electrode layer 904, of at least a material that is less dissolvable than the pre-filled material, such as platinum, and an insulating pattern layer 906, is positioned in close physical contact with the conducting top layer or seed layer 908, on the substrate 10 in the presence of an electrolyte 912, forming electrochemical cells, filled with electrolyte, defined by the cavities of the insulating structures on the master 902.

Positioning the master 902 in close contact with the top layer on the substrate 910 may include aligning the master insulating pattern 906 to the patterned layer on the substrate 910. This step can include the use of alignment marks of the master which alignment marks can be aligned to the corresponding alignment marks on the substrate.

Before positioning the master in contact with the substrate, pre-deposited anode material 914 may be arranged onto said conductive electrode layer 904 in the cavities defined by the conductive surface of the master 902 and the insulating pattern layer 906. Said pre-deposited anode material 914 in the cavities of the master can be cleaned and activated, in the same manner as described for the substrate seed layer, before positioning the master into contact with the substrate. Said electrolyte may comprise a solution of cations and anions appropriate for electrochemical etching and/or plating.

In the second step (b), structures of conducting material can be formed using an ECPR printing unit by plating applying a voltage, using an external power source, to the master 902 and to the seed layer 908 on the substrate 910 for creating an electrochemical process simultaneously inside each of the electrochemical cells defined by the cavities of the master 902 and the top layer on the substrate 910. When the voltage is applied in such a manner that the conducting electrode layer 904 in the master 902 is anode and the seed layer 908 of the substrate 910 is cathode, the pre-deposited anode material 914 inside the cavities of the master can be dissolved and at the same time material 916 is deposited on the conducting layer on the substrate 910 in the cavities that are filled with electrolyte 912. The deposited material on the conducting layer on the substrate 910 forms structures that are a positive image of the cavities of the insulating pattern layer 906 of the master 902, whereby ECPR plated structures 916 are formed.

Said ECPR etched or ECPR plated structures can be comprised of conducting materials, such as metals or alloys, for instance Ag, Ni, Cu, Sn, SnAg, SnAgCu, AgCu and/or combinations thereof.

In some embodiments of the present invention, said anode material is pre-deposited by regular electroplating, electro less plating, reversed ECPR plating where ECPR contact etching is performed from a metal source, immersion plating, Chemical Vapor Deposition (CVD), Metal-Organic Chemical Vapor Deposition (MOCVD), powder-coating that may be charged, chemical grafting and/or electro grafting said material selectively onto the conducting electrode layer in the cavities of the insulating pattern layer of the master.

The voltage can be applied in a manner that improves the uniformity and/or properties of the etched and/or plated structures. The applied voltage can be a Direct Current (DC) voltage, a pulsed voltage, a square pulsed voltage, a pulse reverse voltage and/or a combination thereof.

The uniformity of the printed structures can be increased by choosing an optimized combination of applied voltage waveform, amplitude and frequency. The etch depth or plating height can be controlled by monitoring the time and the current passing through the master. If the total electrode area is known, the current density can be predicted from the current passing through the electrode area. The current density corresponds to an etching or plating rate and hence the etching depth or plating height can be predicted from the etching or plating rate and time.

In some embodiments, the printing process is stopped by disconnecting the applied voltage before reaching the underlying surface of the dissolving anode material. For the etching process, this means that the process is stopped when a layer is still remaining in the bottom of the etched grooves in the seed layer, covering the underlying substrate layer. Otherwise, there is a risk that the electric connection to certain portions of the seed layer may be broken. For the plating process, this means that the process is stopped when a layer of pre-deposited anode material still remains, such as 5% to 50%, covering the conducting electrode layer. Otherwise, uneven current distribution may occur in the respective electrochemical cells.

After the ECPR printing step, remaining material deposited inside the cavities of the master can be removed using removal methods that include applying wet etching chemicals suitable for dissolving the remaining materials.

Alternatively, during plating, only a portion of the pre-deposited material may be used in a single procedure and another portion of the pre-deposited material may be used in the next procedure, for a number of procedures. Alternatively, during etching, the material deposited on the cathode, i.e. the master, may not need to be removed between each procedure, but may be removed between each second, third etc procedure.

After the ECPR printing step, a seed layer on the substrate can be removed by performing seed etching in a clean and etch chamber of a cleaning unit using etching methods that include wet spray etching, immersion etching or dry plasma etching.

According to some embodiments of the present invention the printing unit may be a ECPR printing unit, that is a semiconductor manufacturing tool unit manufacturing tool unit that can perform steps involved in transferring a metal pattern from a pre-filled ECPR master using the ECPR Process onto a substrate having a conducting seed layer to receive a metal pattern that is thereby replicated. The ECPR printing unit can perform operations comprising alignment of the ECPR master and the substrate, electrolyte filling of the master, pressing the master and the substrate together in close contact, performing electrolysis using the ECPR Process for metal transfer, physical separation of the master and the substrate, cleaning and/or drying of the master and substrate, loading and/or unloading of the substrate and the master. The ECPR printing unit may also comprise a computer control unit that can be used to manage print recipes of various parameter settings, execute said recipes, monitor the ECPR process, perform data logging during the ECPR process and deliver reports on measured parameters and performance of steps within the ECPR process. The computer control unit can be configured to communicate with the system level control software of the integrated ECPR system using a pre-defined communication protocol for communicating print related data such as the respective process parameters, print recipes, print log-files, print reports, print status signals, hand-shake signals, and printing error signals.

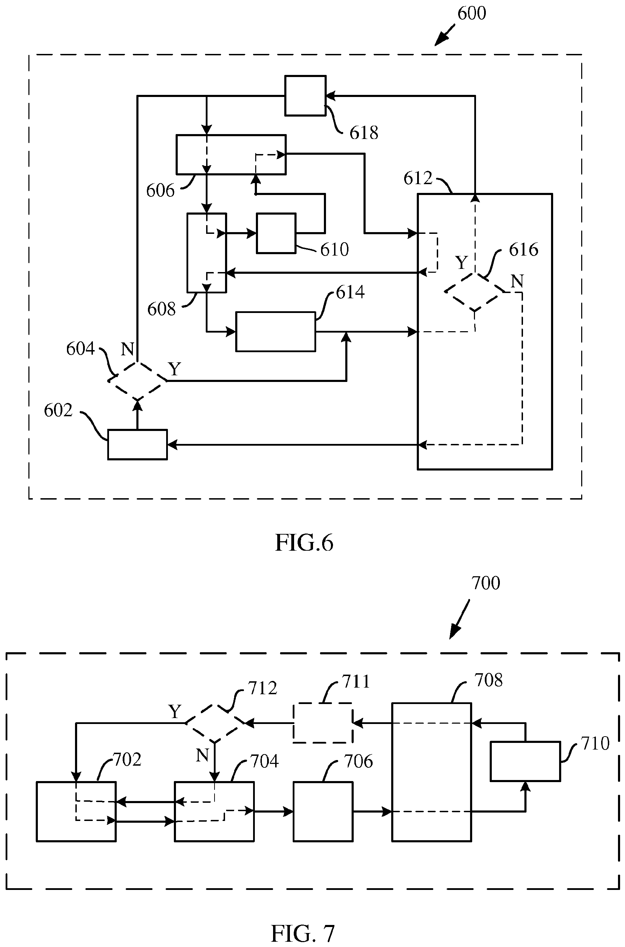

With reference to figure 6 presenting a schematic flow path 600 of a master wafer, according to some embodiments of the present invention, different steps as operated by the robot unit 516 shall be described.

During the ECPR process the master can be contaminated and therefore requires cleaning. In figure 6, as well as in a forthcoming figure 7, transport lines at least directly preceding the cleaning unit 612, 704 denote a transport of a wafer that is dirty or at least contaminated, and hence has to be cleaned. Consequently, lines at least directly after the cleaning unit 612, 704 denote transport of a clean wafer.

Since embodiments of the present invention comprise the handling of dirty and clean wafers with different end effectors, contamination and therefore required cleaning steps can be kept to a minimum. At least partly due to the progress of handling masters and substrates with different end effectors, very low levels of impurities and contamination can be maintained in the local environment of a ECPR system.

Now, from for instance a master Front Operating Unified Pod (FOUP), which may be comprised within the master wafer carrier 602, a logical query 604 can determine whether the master needs cleaning or not.

If the logical unit 604 considers that the master does not need to be cleaned, the master is transported with a clean end effector 518, as indicated in Fig. 5, to a flipping unit 606.

The flipping unit 606, also called flipper unit can be a master or substrate handling unit that is configured to flip a master or substrate by changing the orientation of the wafer by rotation. Typically a rotation of pi radians, i.e. 180 degrees, is performed with respect to the wafer's prior orientation. The two planar sides of the master can in this sense be considered to be interchanged upon flipping.

In some embodiments of the present invention a flipping mechanism of the flipping unit for performing the flip is integrated in the pre-aligning unit. In some r embodiments of the present invention the flipping mechanism is realized as a stand-alone flipping unit within the integrated ECPR system. The flipping unit as described in the embodiments above is preferably used together with edge grip end effectors or other end effectors that do not make physical contact with the planar surfaces of a wafer, at least not in the region inside the edge exclusion zone when handling masters or substrates. In some embodiments of the present invention the flipping mechanism is integrated on a robot arm as a wrist that can be used to flip an end-effector of the robot 180 degrees or pi radians. In these embodiments of the present invention the end-effector can be a backside grip vacuum paddle. In some embodiments of the invention a flipping unit can be configured with two wafer-flipping ports, of which one is for flipping wafers that are known to be clean and the other for flipping wafers that are potentially contaminated.

Subsequent to flipping the master in flipping unit 606, said master is typically oriented face down, with the pattern of replication facing down. The master facing down is then transported to a pre-aligning unit 808 configured to centre and align the master, enabling a proper metal filling in the subsequent filling unit 610.

At the filling unit 610, the master is then pre-filled with a material, such as a metal, which later may be plated or etched. Having pre-filled the cavities of the master in the filling unit 610, the master is then transported by a potentially contaminated end effector 520, back to the flipping unit 606 in order to be flipped pi radians again by the flipping unit 606.

It can be noted that the cleaning step may be performed prior to the filling step, according to an alternative embodiment. For cleaning and activation of a master prior to ECPR printing, a wet chemical spray process, a spin and wet chemical dispense process, a wet immersion process or a dry plasma process may be used.

Following the master flow in figure 6; from the flipping unit 606 the master can then be transported to the cleaning unit 612, by the potentially contaminated end effector 520. The master is cleaned in the cleaning unit 612 and transported by the clean end effector 518 to the aligning unit 608. This aligning unit 608 is now configured to align the master in a well-defined position.

It should be mentioned that the flow as described above refers to ECPR plating where anode material is filled in the cavities of the master by the filling unit.

In the case of reverse ECPR, ECPR printing is performed by ECPR etching structures in a seed layer on a substrate. Since material is etched from the seed layer and deposited in the cavities of the master, the master does not need to be filled by material. For this reason, a master flow corresponding to the one as described above will neither use the flipping unit 606 nor the filling unit 610. Moreover the step of cleaning in the cleaning unit 612 between flipping in the flipping unit 606 and aligning in the aligning unit 608, is also not required. Consequently, in the case of N in step 604, or after having passed the buffer unit 618, the next step is to pre-align the master in the aligning unit 608 before printing in the printing unit 614.

By retaining the alignment of the master, the master is thus transported to the printing unit 614 by a clean end effector 518, enabling a successful result in the step of printing.

After printing in the printing unit 614 a small amount of pre-filled metal may remain in the master or alternatively at least the master may be contaminated, which requires a cleaning for which reason the master is transported with the potentially contaminated end effector 520 to the cleaning unit 612.

In order to enable a competitive performance in the ECPR process within the integrated ECPR system, it is investigated whether the master needs to be replaced by another master. This investigation is performed in the logical unit 616 at which it is determined whether a master counter that is incremented upon each usage cycle, is still for instance below an upper limit or not. If the counter has reached the upper limit, said master is transported to the master FOUP 602 for retaining used masters. In the case the master counter is lower than said upper limit for continued guaranteed usage, the master is transported to a master buffer 618 configured to temporarily store masters. In the case the counter is below the upper limit and the number of masters is low, the clean end effector 518 may continuously forward the master to the flipping unit 606 for continued processing.

It can be determined by a controlling means such as a system level control software of the integrated ECPR system whether to use a master from the master FOUP 602 or to use another clean master from the master buffer 618. It should be mentioned that several masters may be operated simultaneously within one integrated ECPR system for which reason an optimization of the operation of the end effectors as operated by the robot unit 516 and controlled by the integrated ECPR system may be performed by for example the system level control software.

The system level control software, including a wafer scheduler application can control the transport of substrates and masters between process units. Moreover, the scheduler application can be configured to control hand-shakes between different processing units, selection of processing recipes, data logging, error signaling and alarming for the processing units.

The integrated ECPR system can also comprise a substrate and master flow simulator and optimizer for optimizing the throughput and the quality of the printed substrates.

In the case the master from the master FOUP 602 is determined to be clean in logical unit 604, the master is directly transported by the clean end effector 518 to the flipping unit 606, for continued operation as described above.

In the case the master from the master FOUP 602 is not sufficiently clean as determined in logical unit 604, the master is transported by the potentially contaminated end effector 520 to the cleaning unit 612 to clean the master.

It should be mentioned that the logical query in logical unit 604 determines whether the masters is required to be subjected to a brief cleaning step in which dust and contamination particles can be removed by rinsing and drying the master. The master when being transported from the master FOUP 602 may therefore be handled by the clean end effector 518.

In parallel with the transport of one or more masters by either the potentially contaminated end effector 520 or by the clean end effector 518, one substrate per each handled master can also be handled by said end effectors 518, 520. It is easy to realize that the process of simultaneous handling of one or more masters and one or more substrates requires a proper scheduling of process steps and setting of timing parameters for the processes and the required transfers of masters and substrates not to risk collisions and damages to substrates and /or masters. In addition, further optimization of scheduling is often required to optimize the throughput of substrates.

Below, with reference to figure 7 presenting a schematic flow path 700 of a substrate, according to some embodiments of the present invention, different steps as operated by end effectors 518, 520 of the robot unit 516 shall be described.

Starting from a substrate carrier 702, which may be the substrate carrier 504 of figure 5, a substrate is transported to a cleaning unit 704 by the potentially contaminated end effector 520, to certify that the substrate for further handling is sufficiently clean in order to neither contaminate the clean end effector 518, nor one or more masters is use. Having cleaned the substrate by cleaning unit 704 the substrate is transported by the clean end effector 518 to a pre-aligning unit 706, wherein the substrate is aligned for centering and alignment of the substrate. The aligned substrate is then transported to a flipping unit 708, configured to turn the substrate upside down by rotating the substrate pi radians. The upside down turned substrate is then transported by the clean end effector to a printing unit 710. The clean end effector is responsible for the transport of the substrate from the flipping unit 708 to the printing unit 710. Within the printing unit 710 the substrate is plated with metal from a pre-filled master.

After the printing unit 710, the substrate can be transported by the potentially contaminated end effector 520 to the flipping unit 708. The substrate can further be transported by the same end effector 520 to an annealing unit 711 for annealing of the metal plated. The substrate may then be transported either to the cleaning unit 704 or to the substrate carrier 702 based on whether the substrate is considered to be sufficiently clean by the logical unit 712, or not. The annealing unit 711 may alternatively be positioned after the cleaning step of seed etching in the cleaning unit 704 before transporting the substrate to the substrate carrier 702.

Thus, the annealing unit 711 can be configured to thermally treat or anneal a printed substrate electrode prior to cleaning by the cleaning unit 704. Alternatively, the annealing unit 711 may be configured to thermally treat or anneal a seed etched substrate prior to transport to the substrate carrier 702.

Thermal treatment may comprise annealing, such as Rapid-Thermal-Annealing, RTA, furnace heating, hot-plate heating or combinations thereof; wherein said methods may be performed in an environment which substantially comprises: vacuum, forming gas, hydrogen gas, nitrogen gas, low oxygen content or combinations thereof. The thermal treatment can improve the electrical and/or mechanical properties of the substrate such as hardness and/or wear resistance, by reducing internal stress and/or contact resistance.

In case the substrate is considered to be contaminated the substrate is transported by the at least potentially contaminated end effector 520 to the cleaning unit 704. Thereafter, the clean substrate can be transported by the clean end effector 518 to the substrate carrier 702.

It should be mentioned that although each kind of processing units as described in figures 6 and 7 have been described independently in relation to one another, at least according to some embodiments these may be realized by a single processing unit. For instance, the flipping unit as presented in figure 6 and denoted 606, and the flipping unit in figure 7 and denoted 708, may thus be realized as the same singular flipping unit.

Similarly, the pre-aligning unit 608 and the pre-aligning unit 706 may be realized by one singular pre-aligning unit.

The printing unit 614 and printing unit 710 is typically the same unit, as the printing unit for the ECPR process requires a master as well as a substrate. Within larger integrated ECPR systems two or more printing units may however also be realized, as indicated in Fig. 5 as two printing units 510, 524.

Although the presented integrated ECPR system presented above and illustrated in figure 5 is illustrated as having a certain configuration, other different configurations may alternatively be used. As indicated in Fig. 4, a differently formed platform may alternatively be used. Process units may be positioned in a radial fashion around a robot unit having end one or more effectors. Process units can be arranged side by side or on top of each other in a stacked fashion.

The integrated ECPR system can be extended with additional components, process units that are easily added and connected to the integrated ECPR system.

Also, it is envisaged that different processing units may be operated at different pressures. Various vacuum levels and various gas mixtures can be used if desired for different processing steps. This is enabled by usage of the housing 534 as illustrated in Fig. 5.

At least according to some embodiments the integrated ECPR system may be controlled via a system level control software including a wafer scheduling application for scheduling of a sequence of operational steps for each integrated ECPR system unit, enabling carrying out an operation recipe for tailored operation of the units as comprised within an integrated ECPR system. Via a factory automation interface or a system control interface, the ECPR system can be controlled.

The system control interface of the integrated ECPR system can comprise a computer or a software controller, comprising computer readable program code, which when inserted in said computer or software controller can perform processing steps within methods for replication of a pattern of a integrated ECPR system.

The integrated ECPR system according to embodiments of the present invention has a number of advantages effects of which a few will be described in more detail below.

Among the vast number of effects and advantages that can be identified over prior art techniques, some effects and advantages will herein be mentioned explicitly.

Timing and environment control between the steps of pre-filling a master and printing the substrate using the master, affects printing quality.

Due to spontaneous and continuous grain modification that take place for many types of pre-filled metals, for instance spontaneous grain growth of electroplated copper at room temperature, the significantly longer waiting times associated with prior art ECPR processing step, aggravated by less controlled environments in different wafer carriers, give rise to variations in grain size and structure of pre-filled metal in masters. Both the quality of printed metal structures, for instance uniformity and roughness variations, as well as the reliability of the metal transfer process, for instance variations from target metal thickness, is depending on the grain size and surface roughness of the pre-filled material which affects the dissolution during the metal transfer process in electrochemical microcells as used in ECPR printing.

It must be explicitly noted that minimized and highly repeatable waiting times for masters and substrates between processing units in a controlled environment are critical for the quality of the printed metal patterns as formed in the printing unit. For comparative purposes it can be mentioned that in an ambient environment, gas at various compositions may be present, temperature can be fault, and particle density is not well suited for semiconducting processing steps, such as steps within processing units in the integrated ECPR system.

Timing and environment control between the steps of cleaning/surface activation and printing the substrate using the master, affects surface conditions of the master and the seed layer of the substrates.

By integrating the filling unit and the printing unit into one integrated ECPR system, the elapsed time for wafer transport between wafer treatment in said pre-filling time and the subsequent printing unit as well as time variations can be minimized. By providing a well controlled local environment inside the integrated ECPR system both the total amount of spontaneous grain modification as well as the wafer-to-wafer variation between metal filling and printing can be minimized. The effect is improved control of the dissolution of pre-filled metal from the master during printing, enabling improved uniformity and roughness of printed metal as well as better reliability of printing by minimizing the risk for forming electrical short-cuts in microcells.

The risk to form electrical shorts in microcells during printing has been observed to be depending on several parameters, one being dissolution of relatively large chunks or pieces of metal in the case of pre-filled metal with larger grains, which increases the risk of electrical short-cuts.

By integrating the process units for cleaning and printing into one ECPR system according to some embodiments of the present invention, the waiting time and wait time variations wafer-to-wafer, is minimized. Also, by providing a well controlled mini-environment inside the integrated system both the total amount of surface modification as well as the wafer-to-wafer surface variations between cleaning and printing can be minimized. The effect is improved grains size and roughness control, improved adhesion between printed structures and seed layers as well as reduced defectivity such as dislocations and voids, resulting from cleaner and more repeatable metal surfaces for seed layers and prefilled metal in printing within the ECPR printing unit.

Timing and environment control between the steps of printing and seed etch step of the substrates affect the grain size of metal and thereby roughness post seed etch as well as the selectivity between plated metal and seed layer metal.

By integrating the printing process unit and cleaning unit configured for seed etching into one integrated ECPR system, the waiting time and waiting time variations wafer-to-wafer, is minimized. By providing a well controlled local environment inside the integrated ECPR system both the total amount of spontaneous grain modification as well as the wafer-to-wafer variation between printing and seed etching can be minimized. Advantageous effects are improved control of the surface roughness and etch selectivity to the seed layer during the seed layer etching in the cleaning unit configured for etching.

The integrated ECPR system comprising integrated tool units, applying a single wafer flow also has the following advantages:
- The throughput of an ECPR production line can be maximized using a given small amount of masters. A maximized throughput for a minimal number of masters can therefore be reached. Assuming an ECPR process line having a given number of ECPR print units a problem with prior art is to keep the print unit fully occupied in printing at any time thereby maximizing the throughput. This is because a second master needs to be filled in parallel with a third master that is being cleaned in order to have a filled and clean master ready for next print cycle of fill, cleaning and print, at the time of unloading a first master in a first print cycle. In the case stand-alone tools were to be used for filling, cleaning and printing, the problem would be that transport of wafers from one tool to the other is done using standard wafer carriers, typically holding 25 wafers in each carrier. In order to have one carrier simultaneously on all three tools, at least three carriers with masters will be needed in order to keep the process line fully loaded. Even if the number of masters per carrier is reduced to a low number, for instance 5 which can still be practically possible from a carrier swap-cycle perspective, in an attempt to reduce the number of required masters, 15 masters would still be required to maintain a process line loaded. This number should be compared to the low number of 3 masters in the case of an integrated ECPR system according to embodiments of the present invention where each of the three masters is moved independently between process units keeping the ECPR process line fully loaded.
- Minimizing ECPR cycle time, i.e. the time required for one ECPR process cycle, short feedback loops giving timely and accurate feedback to the process units and/or robot control unit controlling the end effectors of the robot unit, increasing statistical process control effectiveness, which all together enable higher substrate yields of the integrated ECPR system.
- By counting each time a master is used in a printing cycle within the integrated ECPR system, a master never has to leave the ECPR system before it has reached end of life, which reduces wear of the master and the time which otherwise would be needed to control the current quality of the master.
- By using an integrated ECPR system comprising a system level control unit, an effective tracking of process data between fill, print, cleaning units can easily be obtained, enabling optimizing of a high throughput of high quality substrates.
- An integrated ECPR system having a system level control unit enables integrated and fully automated software (SW) for tracking, simulating and balancing of the master flow and the substrate flow, to obtain the target of keeping the printing unit constantly occupied using a minimum amount of masters and substrate in the flow.
- Provision of a wafer flow simulator and optimizer that by the use of logical rules and timing rules defined for masters and substrate at each step in the integrated flow, for instance between seed activation in a cleaning unit and printing in the printing unit, performs simulation of the effective cycle times and throughput associated with a certain master or substrate handling sequence and or move priority pattern for the robot unit. By analyzing the output result from a large number of possible master and substrate handling sequences and or move priority patterns for the robot unit, an optimized master and substrate flow scheduling with minimized overall waiting times can be automatically generated, thereby realizing an automatic wafer flow optimizer for the integrated ECPR system that will derive the most favorable operation point of the system for any given ECPR process specification.
- By integrating the processing units on one and the same tool platform, a master can be re-used a large number of times without loading/unloading it to a carrier and the lifetime can be increased by reduced mechanical handling and wear. It also reduces the risk of breaking the masters upon a handling error.
- By using a single-wafer flow of master and substrates, the elapsed time until the first substrate has been completed and can leave the integrated ECPR system, the so called first-wafer delay, is substantially decreased as compared to batch-wise handling of, at least, substrates. At the time the first printed substrate from an integrated ECPR system is thus completed, a number of substrates are still being processed, using batch-wise processing, without having a single substrate being completed. This is a clear drawback especially in relatively small series of substrates.

It should furthermore be mentioned that the elements and components of an embodiment of the invention may be physically, functionally and logically implemented in any suitable way. Indeed, the functionality may be implemented in a single unit, in a plurality of units or as part of other functional units. As such, the invention may be implemented in a single unit, or may be physically and functionally distributed between different units and processors.

Although the present invention has been described above with reference to specific embodiments, it is not intended to be limited to the specific form set forth herein. Rather, the invention is limited only by the accompanying claims and, other embodiments than the specific above are equally possible within the scope of these appended claims.

## Claims

1. An integrated Electro Chemical Pattern Replication, ECPR system (500) for performing electrochemical printing of nano or micro structures, using a master, onto a conductive surface of a substrate, comprising:
- a housing (534);
- a filling unit (202, 304, 404, 508, 610) and a cleaning unit (406, 512, 612, 704), where the master is an electrode with an insulating patterned layer forming cavities, where the filling unit is configured to deposit a material in the cavities of the master, and the cleaning unit is configured to clean at least one of the surface of the substrate and/or a surface of the master;
- an ECPR printing unit (206, 308, 408, 510, 524, 614, 710) configured to electrochemically transfer material, either deposited in the master cavities in a filling unit, as nano or micro structures from the master to the conductive surface of the substrate in electrolyte filled cells, which are formed by the master cavities and the conducting surface of the substrate when placing the master in close contact with the substrate or by dissolving material from the substrate while depositing said material in the master by use of the electrolyte filled cells, which are formed by the master cavities and the conducting surface of the substrate when placing the master in close contact with the substrate;
- a tool platform (526) comprising a master and substrate robot unit (516) having at least one end effector (518, 520) configured to grip, fold, transfer and release the master or the substrate, the tool platform (526) further comprising a robot control unit (536) and a scheduler that are configured to control the robot unit (516) for handling the master and the substrate in a single wafer flow, and to provide instructions for handling of masters and substrate to the integrated ECPR system, respectively,
wherein the housing (534) is configured to enclose the filing unit, the cleaning unit and the ECPR printing unit, and to provide a confined interior having a sub-environment of the integrated ECPR system (500)

2. The integrated ECPR system (500) according to claim 1, wherein the housing (534) further is configured with one or more load ports (532) for accepting and returning carriers of masters and substrates.

3. The integrated ECPR system (500) according to any one of claims 1-2, where the tool platform (526) further comprises at least one of a temperature control unit (528) and a particle filtering unit (530), wherein the temperature control unit is configured to control the temperature of the interior of the integrated ECPR system, and the particle filtering unit (530) is configured to filter inlet air for the integrated ECPR system.

4. The integrated ECPR system (500) according to claim 3, wherein the temperature control unit (528) further is configured to control the temperature of process fluids for at least one of the filling unit, the cleaning unit and the ECPR printing unit.

5. The integrated ECPR system (500) according to any one of claim 1-4, wherein the filling unit comprises one or more electroplating units, an electro-less deposition unit, an ECPR process unit configured to perform a reverse ECPR process , or a selective Chemical Vapor Deposition, CVD, unit.

6. The integrated ECPR system (500) according to any one of claim 1-5, wherein the cleaning unit comprises a spin and wet chemical dispense unit, a wet immersion process unit or a dry plasma process unit, wherein the spin and wet chemical dispense unit is configured to perform a wet chemical spin-spray process or a wet chemical spray process.

7. The integrated ECPR system (500) according to any one of claim 1-6, further comprising an annealing unit configured to anneal the substrate having material transferred from the master, or at least one annealing unit (513, 711) being integrated with at least one of the ECPR printing unit, the filling unit and the cleaning unit.

8. The integrated ECPR system (500) according to any one of claims 1-7, further comprising an aligning unit (514, 608, 706) configured to align the substrate and the master into first positions thereof.

9. The integrated ECPR system (500) according to any one of claims 1-8, further comprising a master buffering unit (618) configured to temporarily house at least one master, for provision of a used master to an end effector (518, 520) for transport of said used master to the filling unit.

10. The integrated ECPR system (500) according to any one of claims 1-9, further comprising a counter (616) configured to increment a counter value upon passage of a master, for counting the number of prints performed by using each master, and where the scheduler further is configured to determine whether the master is to be returned to a master carrier (302, 504, 602) enabling recycling of the master, or to be further used within the ECPR system.

11. The integrated ECPR system (500) according to any one of claims 8-10, wherein the aligning unit (514, 608) further comprising a flipping unit (606) configured to change the orientation of the master or the substrate, such that the master and the substrate will have a first orientation in the master carrier (302, 504, 602) and the substrate carrier (306, 502, 702), respectively, while one of the master and the substrate will have a second orientation in the ECPR printing unit.

12. The integrated ECPR system (500) according to any of the preceding claims, comprising a second cleaning unit (522, 204) wherein one cleaning unit (512, 208) comprises an etching unit configured to etch away remaining metal from the master after transfer of metal from the master to the substrate in the ECPR printing unit (510, 524, 206), and configured for etching or activation of the seed layer of the substrate, and wherein the second cleaning unit (522, 204) comprises a particle removing unit for rinsing and drying the master and the substrate.

13. The integrated ECPR system (500) according to any of the preceding claims, further comprising a substrate and master flow simulator and a flow optimizer.

14. The integrated ECPR system (500) according to any of the preceding claims, further comprising system level control software comprising a wafer scheduler application for scheduling in time the transport of substrates and/or masters between, as well as the processing itself within various processing units, comprising at least one of the filling unit (202, 304, 404, 508, 610) and the cleaning unit (204, 208, 406, 512, 522, 612, 704), and the ECPR printing unit (206, 308, 408, 510,524, 614, 710).

15. The integrated ECPR system (500) according to claim 14, wherein the wafer scheduler application within the system level control software further is configured to control hand-shakes between the units, to select printing recipes for printing on the substrates, to perform data logging of steps and processes being performed within the integrated ECPR system, and to control error signals and alarms for the units.

## Patentansprüche

1. Integriertes elektro-chemisches Strukturreplikationssystem, ECPR-System (500), zur Durchführung elektrochemischen Druckens von Nano- oder Mikrostrukturen, unter Anwendung eines Masters, auf eine leitfähige Oberfläche eines Substrats, umfassend.
- ein Gehäuse (534);
- eine Fülleinheit (202, 304, 404, 508, 610) und eine Reinigungseinheit (406, 512, 612, 704),
wobei der Master eine Elektrode mit einer isolierenden strukturierten Schicht, die Hohlräume bildet, ist, wobei die Fülleinheit dazu eingerichtet ist, ein Material in den Hohlräumen des Masters anzubringen, und die Reinigungseinheit dazu eingerichtet ist, mindestens eines der Oberfläche des Substrats und/oder einer Oberfläche des Masters zu reinigen;
- eine ECPR-Druckeinheit (206, 308, 408, 510, 524, 614, 710), die dazu eingerichtet ist, auf elektrochemische Weise Material zu übertragen, entweder in den Master-Hohlräumen in einer Fülleinheit angebracht, als Nano- oder Mikrostrukturen von dem Master auf die leitfähige Oberfläche des Substrats in elektrolytgefüllten Zellen, die durch die Master-Hohlräume und die leitfähige Oberfläche des Substrats gebildet werden, wenn der Master in engen Kontakt mit dem Substrat gebracht wird, oder durch Auflösen von Material von dem Substrat während des Anbringens des Materials in dem Master durch Anwendung der elektrolytgefüllten Zellen, die durch die Master-Hohlräume und die leitfähige Oberfläche des Substrats gebildet werden, wenn der Master in engen Kontakt mit dem Substrat gebracht wird;
- eine Werkzeugplattform (526), eine Master- und Substrat-Robotereinheit (516) umfassend, die mindestens einen Endeffektor (518, 520) aufweist, der dazu eingerichtet ist, den Master oder das Substrat zu greifen, falten, übertragen und freizugeben, wobei die Werkzeugplattform (526) weiter eine Robotersteuereinheit (536) und eine Ablaufsteuerung umfasst, die dazu eingerichtet sind, die Robotereinheit (516) zur Handhabung des Masters und des Substrats in einem einzigen Waferstrom zu steuern, beziehungsweise dem integrierten ECPR-System Instruktionen zur Handhabung von Masters und Substrat zukommen zu lassen,
wobei das Gehäuse (534) dazu eingerichtet ist, die Fülleinheit, die Reinigungseinheit und die ECPR-Druckeinheit zu umschließen und einen eingeschränkten Innenbereich zur Verfügung zu stellen, der eine Subumgebung des integrierten ECPR-Systems (500) aufweist.

2. Integriertes ECPR-System (500) nach Anspruch 1, wobei das Gehäuse (534) weiter mit einer oder mehreren Ladestellen (532) zur Annahme und Rückführung von Trägern von Mastern und Substraten eingerichtet ist.

3. Integriertes ECPR-System (500) nach einem der Ansprüche 1-2, wobei die Werkzeugplattform (526) weiter mindestens eines einer Temperatursteuereinheit (528) und einer Partikelfiltereinheit (530) umfasst, wobei die Temperatursteuereinheit dazu eingerichtet ist, die Temperatur des Innenbereichs des integrierten ECPR-Systems zu steuern, und die Partikelfiltereinheit (530) dazu eingerichtet ist, Einlassluft für das integrierte ECPR-System zu filtern.

4. Integriertes ECPR-System (500) nach Anspruch 3, wobei die Temperatursteuereinheit (528) weiter dazu eingerichtet ist, die Temperatur von Prozessfluiden für mindestens eines der Fülleinheit, der Reinigungseinheit und der ECPR-Druckeinheit zu steuern.

5. Integriertes ECPR-System (500) nach einem der Ansprüche 1-4, wobei die Fülleinheit eine oder mehr Elektroplattiereinheiten, eine elektro-lose Abscheidungseinheit, eine ECPR-Prozesseinheit, die dazu eingerichtet ist, einen umgekehrten ECPR-Prozess durchzuführen, oder eine Einheit zur selektiven chemischen Dampfabscheidung, CVD, umfasst.

6. Integriertes ECPR-System (500) nach einem der Ansprüche 1-5, wobei die Reinigungseinheit eine chemische Schleuder- und Nass-Abgabeeinheit, eine Nasstauchprozesseinheit oder eine Trocken-Plasmaprozesseinheit umfasst, wobei die chemische Schleuder- und Nass-Abgabeeinheit dazu eingerichtet ist, einen chemischen Schleuder-Sprüh-Nassprozess oder einen chemischen Sprüh-Nassprozess durchzuführen.

7. Integriertes ECPR-System (500) nach einem der Ansprüche 1-6, weiter eine Ausglüheinheit umfassend, die dazu eingerichtet ist, das Substrat, das von dem Master übertragenes Material aufweiset, auszuglühen, oder mindestens eine Glüheinheit (513, 711), die mit mindestens einem der ECPR-Druckeinheit, der Fülleinheit und der Reinigungseinheit integriert ist.

8. Integriertes ECPR-System (500) nach einem der Ansprüche 1-7, weiter eine Ausrichteinheit (514, 608, 706) umfassend, die dazu eingerichtet ist, das Substrat und den Master in erste Positionen hiervon auszurichten.

9. Integriertes ECPR-System (500) nach einem der Ansprüche 1-8, weiter eine Masterpuffereinheit (618) umfassend, die dazu eingerichtet ist, mindestens einen Master zeitweilig unterzubringen, zur Bereitstellung eines benutzten Masters für einen Endeffektor (518, 520) zum Transport des benutzten Masters zu der Fülleinheit.

10. Integriertes ECPR-System (500) nach einem der Ansprüche 1-9, weiter einen Zähler (616) umfassend, der dazu eingerichtet ist, bei Passieren eines Masters einen Zählerwert zu inkrementieren, um die Anzahl durch Abwendung jedes Masters durchgeführter Drucke zu zählen, und wobei die Ablaufsteuerung weiter dazu eingerichtet ist, zu bestimmen, ob der Master zu einem Masterträger (302, 504, 602) rückzuführen ist, wodurch ein Recyceln des Masters ermöglicht wird, oder weiter in dem ECPR-System zu verwenden ist.

11. Integriertes ECPR-System (500) nach einem der Ansprüche 8-10, wobei die Ausrichteinheit (514, 608) weiter eine Wendeeinheit (606) umfasst, die dazu eingerichtet ist, die Orientierung des Masters oder des Substrats zu ändern, sodass der Master und das Substrat eine erste Orientierung in dem Masterträger (302, 504, 602) beziehungsweise dem Substratträger (306, 502, 702) haben werden, nährend eines des Masters und des Substrats eine zweite Orientierung in der ECPR-Druckeinheit haben wird.

12. Integriertes ECPR-System (500) nach einem der vorhergehenden Ansprüche, umfassend eine zweite Reinigungseinheit (522, 204), wobei eine Reinigungseinheit (512, 208) eine Ätzeinheit umfasst, die dazu eingerichtet ist, nach der Übertragung von Metall von dem Master zu dem Substrat in der ECPR-Druckeinheit (510, 524, 206), restliches Metall von dem Master wegzuätzen, und zum Ätzen oder zur Aktivierung der Keimschicht des Substrats eingerichtet ist, und wobei die zweite Reinigungseinheit (522, 204) eine Partikelentfernungseinheit zum Spülen und Trocknen des Masters und des Substrats umfasst.

13. Integriertes ECPR-System (500) nach einem der vorhergehenden Ansprüche, weiter einen Substrat- und Master-Durchsatzsimulator und einen Durchsatzoptimierer umfassend.

14. Integriertes ECPR-System (500) nach einem der vorhergehenden Ansprüche, weiter Systemniveau-Steuersoftware umfassend, umfassend eine Wafer-Ablaufsteuerungsanwendung zur zeitlichen Ablaufsteuerung des Transport von Substraten und/oder Mastern zwischen, sowie die Bearbeitung selbst innerhalb verschiedener Bearbeitungseinheiten, umfassend mindestens eines der Fülleinheit (202, 304, 404, 508, 610) und der Reinigungseinheit (204, 208, 406, 512, 522, 612, 704), und der ECPR-Druckeinheit (206, 308, 408, 510, 524, 614, 710).

15. Integriertes ECPR-System (500) nach Anspruch 14, wobei die Wafer-Ablaufsteuerungsanwendung in der Systemniveau-Steuerungssoftware weiter dazu eingerichtet ist, Handshakes zwischen den Einheiten zu steuern, Druckrezepte zum Drucken auf die Substrate auszuwählen, Datenprotokollierung von in dem integrierten ECPR-System ausgeführten Schritten und Prozessen durchzuführen und Fehlersignale und Alarme für die Einheiten zu steuern.

## Revendications

1. Système intégré de réplication électrochimique de motifs, ECPR (500) pour la mise en oeuvre d'une impression électrochimique de nanostructures ou de microstructures en utilisant un élément maître, sur une surface conductrice d'un substrat, comprenant:
- un boîtier (534) ;
- une unité de remplissage (202, 304, 404, 508, 610) et une unité de nettoyage (406, 512, 612, 704), dans lequel l'élément maître est une électrode comprenant une couche d'isolation imprimée formant des cavités, l'unité de remplissage étant configurée pour déposer une matière dans les cavités de l'élément maître et l'unité de nettoyage étant configurée pour nettoyer au moins une surface choisie parmi la surface du substrat et/ou une surface de l'élément maître;
- une unité d'impression ECPR (206, 308, 408, 510, 524, 614, 710) configurée pour transférer de la matière par voie électrochimique, soit par déposition dans les cavités de l'élément maître dans une unité de remplissage, sous la forme de nanostructures ou de microstructures à partir de l'élément maître jusqu'à la surface conductrice du substrat dans des cellules remplies d'un électrolyte qui sont formées par les cavités de l'élément maître et la surface conductrice du substrat lors du placement de l'élément maître en contact étroit avec le substrat, soit par dissolution de la matière à partir du substrat lors du dépôt de ladite matière dans l'élément maître par l'utilisation des cellules remplies d'électrolyte qui sont formées par les cavités de l'élément maître et la surface conductrice du substrat lors du placement de l'élément maître en contact étroit avec le substrat ;
- une plate-forme d'outils (526) comprenant une unité (516) faisant office de robot pour l'élément maître et le substrat, possédant au moins un effecteur terminal (518, 520) configuré pour saisir, plier, transférer et libérer l'élément maître ou le substrat, la plate-forme d'outils (526) comprenant en outre une unité de commande de robot (536) et un programmateur qui est configuré pour commander l'unité (516) faisant office de robot pour la manipulation de l'élément maître et du substrat dans un processus de fabrication de plaquette unique et pour fournir des instructions pour la manipulation des éléments maîtres et du substrat au système ECPR intégré, respectivement,
dans lequel le boîtier (534) est configuré pour renfermer l'unité de remplissage, l'unité de nettoyage et l'unité d'impression ECPR et pour fournir un intérieur confiné possédant un sous-environnement du système ECPR intégré (500).

2. Système ECPR intégré (500) selon la revendication 1, dans lequel le boîtier (534) est également configuré avec un ou plusieurs orifices de chargement (532) pour l'acceptation et le renvoi de supports d'éléments maîtres et de substrats.

3. Système ECPR intégré (500) selon l'une quelconque des revendications 1 à 2, dans lequel la plate-forme d'outils (526) comprend en outre au moins une unité choisie parmi une unité de réglage de la température (528) et une unité de filtration des particules (530), l'unité de réglage de la température étant configurée pour régler la température de l'intérieur du système ECPR intégré et l'unité de filtration des particules (530) étant configurée pour filtrer l'air d'entrée pour le système ECPR intégré.

4. Système ECPR intégré (500) selon la revendication 3, dans lequel l'unité de réglage de la température (528) est en outre configurée pour régler la température des fluides du processus pour au moins une unité choisie parmi l'unité de remplissage, l'unité de nettoyage et l'unité d'impression ECPR.

5. Système ECPR intégré (500) selon l'une quelconque des revendications 1 à 4, dans lequel l'unité de remplissage comprend une ou plusieurs unités choisies parmi des unités d'électrodéposition, une unité de dépôt autocatalytique, une unité pour le processus ECPR configurée pour mettre en oeuvre un processus ECPR inverse, ou une unité de dépôt sélectif en phase vapeur, CVD.

6. Système ECPR intégré (500) selon l'une quelconque des revendications 1 à 5, dans lequel l'unité de nettoyage comprend une unité de distribution chimique par rotation et par voie humide, une unité de traitement par immersion par voie humide ou une unité de traitement au plasma par voie sèche, dans lequel l'unité de distribution chimique par rotation et par voie humide est configurée pour mettre en oeuvre un procédé de centrifugation-pulvérisation chimique par voie humide ou un procédé de pulvérisation chimique par voie humide.

7. Système ECPR intégré (500) selon l'une quelconque des revendications 1 à 6, comprenant en outre une unité de recuit configurée pour la recuisson du substrat possédant une matière transférée à partir de l'élément maître, ou au moins une unité de recuit (513, 711) intégrée à au moins une unité choisie parmi l'unité d'impression ECPR, l'unité de remplissage et l'unité de nettoyage.

8. Système ECPR intégré (500) selon l'une quelconque des revendications 1 à 7, comprenant en outre une unité de mise en alignement (514, 608, 706) configurée pour mettre le substrat et l'élément maître en alignement dans leurs premières positions.

9. Système ECPR intégré (500) selon l'une quelconque des revendications 1 à 8, comprenant en outre une unité (618) de stockage temporaire de l'élément maître, configurée pour héberger temporairement au moins un élément maître pour la fourniture d'un élément maître utilisé à un effecteur terminal (518, 520) à des fins de transport dudit élément maître utilisé en direction de l'unité de remplissage.

10. Système ECPR intégré (500) selon l'une quelconque des revendications 1 à 9, comprenant en outre un compteur (616) configuré pour incrémenter une valeur de comptage lors du passage d'un élément maître, pour le comptage du nombre d'impressions réalisées en utilisant chaque élément maître, et dans lequel le programmateur est en outre configuré pour déterminer le fait de savoir si l'élément maître doit être renvoyé à un support d'élément maître (302, 504, 602) permettant le recyclage de l'élément maître ou être utilisé ultérieurement au sein du système ECPR.

11. Système ECPR intégré (500) selon l'une quelconque des revendications 8 à 10, dans lequel l'unité de mise en alignement (514, 608) comprend en outre une unité de basculement (606) configurée pour changer l'orientation de l'élément maître ou du substrat, d'une manière telle que l'élément maître ou le substrat possède une première orientation dans le support d'élément maître (302, 504, 602) et dans le support de substrat (306, 502, 702) respectivement, tandis que, soit l'élément maître, soit le substrat possède une seconde orientation dans l'unité d'impression ECPR.

12. Système ECPR intégré (500) selon l'une quelconque des revendications précédentes, comprenant une deuxième unité de nettoyage (522, 204), dans lequel une unité de nettoyage (512, 208) comprend une unité de gravure configurée pour éliminer par gravure le métal résiduel à partir de l'élément maître après le transfert du métal de l'élément maître au substrat dans l'unité d'impression ECPR (510, 524, 206), et configurée pour la gravure ou l'activation de la couche d'ensemencement du substrat, et dans lequel la deuxième unité de nettoyage (522, 204) comprend une unité d'élimination des particules pour le rinçage et le séchage de l'élément maître et du substrat.

13. Système ECPR intégré (500) selon l'une quelconque des revendications précédentes, comprenant en outre un simulateur du processus de fabrication du substrat et de l'élément maître et un optimiseur du processus de fabrication.

14. Système ECPR intégré (500) selon l'une quelconque des revendications précédentes, comprenant en outre un logiciel de réglage du niveau du système comprenant une application de programmation de plaquette pour la programmation dans le temps du transport des substrats et/ou des éléments maîtres entre diverses unités de traitement, ainsi que le traitement lui-même au sein des diverses unités de traitement, comprenant au moins une unité choisie parmi l'unité de remplissage (202, 304, 404, 508, 610), l'unité de nettoyage (406, 512, 612, 704) et l'unité d'impression ECPR (206, 308, 408, 510, 524, 614, 710).

15. Système ECPR intégré (500) selon la revendication 14, dans lequel l'application de programmation de plaquette au sein du logiciel de réglage du niveau du système est en outre configurée pour le réglage d'établissements de liaisons entre les unités, pour la sélection de formulations d'impression pour l'impression sur les substrats, pour la mise en oeuvre d'acquisitions de données dans les étapes et les processus qui sont mis en oeuvre au sein du système ECPR intégré et pour le contrôle des alarmes et des signaux d'erreurs pour les unités.
